# FASCICULE DE BREVET EUROPEEN

(11) **EP 1 849 646 B1**
(45) Date de publication et mention de la délivrance du brevet: **23.12.2009**
(21) Numéro de dépôt: 07300989.6
(22) Date de dépôt: 26.04.2007
(51) Int. Cl.: B60K 37/06

(54) **Facade modulaire de planche de bord de véhicule**
Modularer Front für das Armaturenbrett eines Kraftfahrzeugs
Modular front for a vehicle dashboard

(30) Priorité: 28.04.2006 FR 0651539
(43) Date de publication de la demande: 31.10.2007
(73) Titulaire: Peugeot Citroën Automobiles SA, 78943 Vélizy-Villacoublay Cedex (FR)
(72) Inventeur: LEBRETON, Etienne, 92170, VANVES (FR)
(74) Mandataire: Vigand, Régis Louis Michel

(56) Documents cités:
- FR-A1- 2 807 364
- US-A- 6 166 450

## Description

La présente invention concerne une façade modulaire de planche de bord de véhicule, en particulier une façade centrale modulaire de planche de bord automobile.

La façade centrale de planche de bord regroupe, le plus souvent, l'autoradio, le tableau de commande du système de climatisation et quelques boutons de commande destinés, à titre d'exemples, au dispositif de verrouillage centralisé du véhicule ou aux feux de signalisation qui clignotent de façon simultanée pour indiquer une situation de danger.

On connaît des façades qui sont des façades dites « multiplexées », qui ont une partie spécifique constituée de boutons de commande tels que ceux mentionnés ci-dessus, de molettes et d'écrans, afin de réaliser « l'Interface Homme Machine » commune à l'autoradio et au système de climatisation. Cette partie spécifique de la façade dialogue par l'intermédiaire du réseau multiplexé du véhicule. Il y a, par conséquent, dans ces façades multiplexées de l'art antérieur, une réelle intégration de plusieurs fonctions.

Toutefois ce principe d'intégration est antinomique du principe selon lequel est offerte aux clients des véhicules la possibilité de pouvoir se procurer et pouvoir monter un autoradio dit « en seconde monte ». Cette possibilité étant offerte par opposition à l'option classique des autoradios de série, ou à l'option de ne pas s'équiper d'autoradio du tout.

La façade de ces ensembles multiplexés étant monobloc et de configuration unique quelque soit l'option d'autoradio choisie, la difficulté est de réaliser des versions « réduites » pour certaines options sans qu'il soit nécessaire de concevoir et développer de nouveau une version complète de façade.

Le but de la présente invention est de concevoir une nouvelle façade, qui soit d'une telle modularité qu'elle surmonte cette difficulté.

En d'autres termes, le premier but de la présente invention est de pouvoir concilier une façade intégrée multiplexée avec, pour une partie des véhicules produits, des références sans autoradio, de façon à permettre l'option de « seconde monte ».

On connaît aussi, selon la demande de brevet français n° 2 807 364, une structure d'assemblage d'une console centrale de véhicule, qui comporte plusieurs dispositifs électriques assemblés de manière amovible sur un élément de maintien afin d'être retirés depuis l'intérieur d'un compartiment de passagers pendant que l'élément de maintien est fixe sur un tableau de bord. Dans une telle structure, lorsque, par exemple, une platine de disque CD est retirée de la console centrale jusque dans le compartiment des passagers parmi les dispositifs électriques, seule la platine de disque CD peut être retirée de l'élément de maintien jusque dans le compartiment des passagers sans retirer les autres dispositifs électriques, dans un état fixe de l'élément de maintien sur le tableau de bord, ce qui simplifie l'opération d'enlèvement des dispositifs électriques. Cette demande forme le préambule de la revendication 1.

La structure d'assemblage de l'art antérieur, ainsi décrite dans ses grandes lignes, constitue bien une façade avant modulaire, qui peut être une façade centrale modulaire. Toutefois, ce caractère modulaire ne s'étend pas aux circuits imprimés associés aux modules individuels qui constituent la façade.

C'est pourquoi un second but de la présente invention est de concevoir une nouvelle structure de façade modulaire de planche de bord, qui inclut aussi les circuits imprimés ou circuits électroniques associés.

Un autre but de la présente invention est de réaliser la flexibilité impliquée par l'offre des options mentionnées précédemment sans qu'il soit nécessaire d'engager des développements très coûteux, et sans qu'il soit nécessaire de concevoir et développer de nouveau de nombreuses pièces.

Pour parvenir à ces buts, la présente invention réalise une nouvelle façade modulaire de planche de bord automobile, destinée à servir d'interface homme machine à au moins deux systèmes d'équipement automobile à réglages, comprenant un tableau de commande et au moins une carte de circuits imprimés sur laquelle sont montés les composants électriques et électroniques de fonctionnement desdits systèmes. Dans cette nouvelle conception, la carte de circuits imprimés est constituée de deux parties séparées par une ligne de découpe permettant d'amputer la carte d'une desdites parties, et les composants électriques et électroniques essentiels desdits systèmes d'équipement automobile sont tous montés sur l'autre partie.

Les deux systèmes d'équipement automobile à réglages peuvent être, de préférence, le système autoradio et un autre système d'équipement automobile, par exemple le système de climatisation.

Selon un mode de réalisation préféré de l'invention, la partie pouvant être séparée de la carte de circuits imprimés est la partie qui correspond au système autoradio.

La ligne de découpe séparant les deux parties de la carte de circuits imprimés est, de préférence, une ligne droite dirigée selon la longueur de la carte de circuits imprimés.

Lesdits composants électriques et électroniques essentiels desdits systèmes d'équipement automobile comportent au moins les composants suivants : alimentation électrique, microcontrôleurs, mémoires, interface et connectique.

De manière préférentielle, ne traversent la ligne de découpe que les pistes de circuits imprimés, exclusivement.

Et, de préférence également, les pistes de circuits imprimés traversent la ligne de découpe selon des lignes sensiblement perpendiculaires à la ligne de découpe.

De plus, les pistes de circuits imprimés sont, de préférence, dans la zone de la ligne de découpe, éloignées d'une distance suffisante, de façon à ce qu'un découpage imprécis ne puisse pas provoquer de court-circuit.

La ligne de découpe est réalisée de manière à permettre l'un des découpages suivants : découpage type ciseaux, découpage type laser, découpage par cassure manuelle.

Selon l'invention également, la partie pouvant être séparée de la carte de circuits imprimés qui correspond au système autoradio ne comporte que des composants non essentiels, tels des diodes électroluminescentes, et des contacts pour commutation.

De préférence également, les composants non essentiels ne sont pas soudés sur la partie pouvant être séparée de la carte de circuits imprimés, lorsque ladite partie est réellement et physiquement séparée de l'autre partie.

D'autres buts, avantages et caractéristiques de l'invention apparaîtront dans la description qui suit d'un exemple de réalisation de l'invention, non limitatif de la portée de la présente invention, et accompagnée des dessins annexés dans lesquels :
- la figure 1 est une représentation d'une façade de boutons avec une membrane silicone,
- les figures 2A et 2B représentent schématiquement le recto (2A) et le verso (2B) d'une carte de circuits imprimés de façade modulaire, selon la présente invention,
- la figure 3 est une vue représentant l'habillage final de la carte de circuits imprimés découpée, c'est-à-dire le tableau de commande ou de boutonnerie.

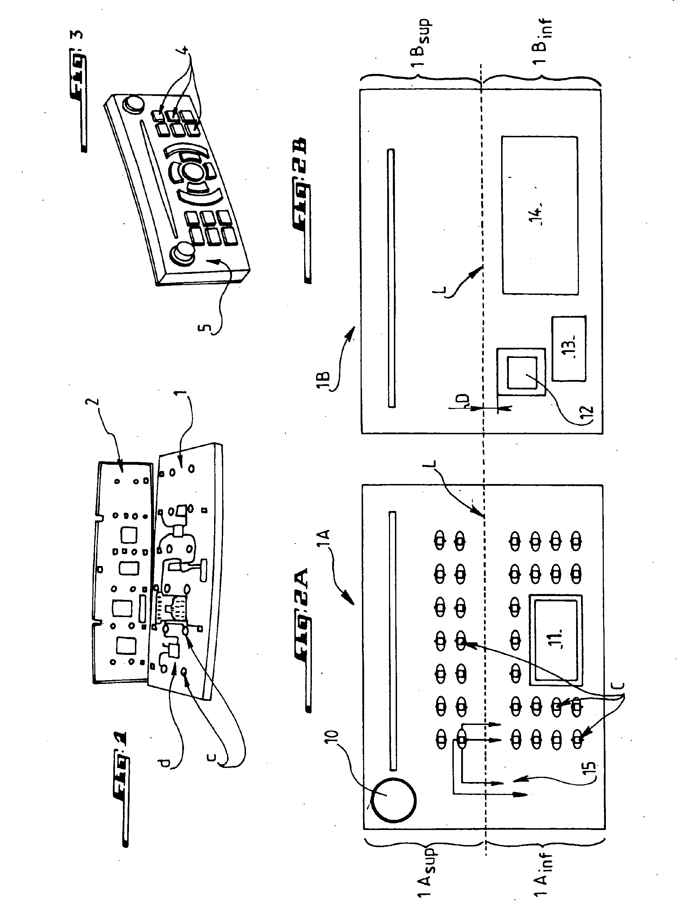

En se référant au dessin de la figure 1, une façade de boutons (avec éventuellement des molettes et des « joysticks » non représentés) est constituée d'un empilage de différentes pièces dont le coeur est la carte de circuits imprimés 1 qui accueille les contacts électroniques « c » et les diodes électroluminescentes (LED) « d ». La référence 2 désigne la membrane silicone avec les contacts carbone.

Selon la présente invention, en référence au dessin des figures 2A et 2B, la carte de circuits imprimés 1 est représentée, de manière schématique, par sa face recto 1A et sa face verso 1B. Les contacts électriques référencés c sont en nombre sur la face 1A de la carte 1 et se trouvent répartis sur la partie supérieure 1Aₛᵤₚ et sur la partie inférieure 1A_{inf} de la face 1A de la carte 1. Les contacts c sont des contacts +/-, avec diode électroluminescente d'éclairage. On a représenté, à titre d'exemples, quelques pistes de circuit imprimé par la référence 15 au voisinage de la ligne de séparation L entre les parties supérieure et inférieure de la carte de circuits imprimés 1. A titre d'exemple non limitatif de l'objet de l'invention, on a également représenté une façade comprenant une molette 10, un écran LCD (acronyme pour l'expression anglaise « Liquid Cristal Display » signifiant « à cristaux liquides »), de référence 11.

Sur la face 1B, face verso, de la carte de circuits imprimés 1, sont situés les composants essentiels. Conformément au principe de la présente invention, ces composants essentiels sont tous situés dans la partie inférieure 1B_{inf} de la carte 1, à savoir les éléments suivants donnés seulement à titre d'illustration du principe : une alimentation 12, un microcontrôleur 13, des mémoires 14, par exemple ainsi qu'une interface et la connectique associée aux éléments.

Ainsi, dans la partie supérieure de la carte 1 ne se trouvent que des diodes électroluminescentes et des contacts électriques carbones ou « microswitches » pour la partie commutation.

La carte de circuits imprimés 1 peut, selon le principe de la présente invention, être « amputée » de la partie supérieure (partie audio) sans endommager l'intégrité des fonctions essentielles de la carte. A cette fin, la partie supérieure de la carte 1 peut être découpée physiquement de la partie inférieure et les règles suivantes de conception de la carte s'appliquent de façon à assurer ladite intégrité .
- seules des pistes de cuivre 15 de la carte traversent la ligne de découpe L, et ces pistes « traversantes » traversent perpendiculairement la ligne de découpe L, de façon à faciliter le découpage,
- les pistes de cuivre 15 sont éloignées les unes des autres d'une distance suffisante, de façon à ce qu'un découpage imprécis selon la ligne de découpe L ne vienne pas provoquer de court-circuit,
- les composants essentiels mentionnés précédemment et situés dans la partie inférieure 1B_{INF} de la carte 1 sont éloignés d'une distance appropriée « D » de la ligne de découpe L, de façon à ne pas subir les torsions de matière dues au découpage selon la ligne de découpe L.

Le découpage physique de la carte 1 en deux parties selon la ligne de découpe L peut se faire selon différents procédés, connus en soi. Il peut s'agir, par exemple, d'un découpage au moyen de ciseaux, ou d'un découpage de type laser, ou encore d'un découpage par brisure manuelle, ou de tout autre découpage approprié connu en soi.

Si la carte de circuits imprimés 1 est destinée à être découpée, la partie audio - partie supérieure - n'est pas utilisée ; en conséquence, les composants de la partie supérieure, à savoir les diodes électroluminescentes ou encodeur, ne seront pas nécessairement soudées sur cette partie non utilisée, pour éviter tout gaspillage.

En se référant maintenant à la figure 3, lorsque la carte de circuits imprimés 1 est découpée, elle est recouverte alors d'une partie de la membrane silicone 2, elle-même préalablement découpée. La carte reçoit ensuite les touches 4 qui correspondent à la partie restante, et enfin un plastron 5 plus petit adapté à la forme réduite.

La présente invention, décrite dans un mode de réalisation préféré ci-dessus, offre de nombreux avantages.

Un premier avantage est de réaliser un dispositif qui permet de concilier une façade intégrée multiplexée avec, pour une partie des véhicules produits, des références sans autoradio, lesquelles autorisent une possibilité d'autoradio en seconde monte.

On a donc, grâce à la présente invention, obtenu une flexibilité de fabrication. Et cette flexibilité est offerte sans entraîner de frais de développement importants, parce que les options sont réalisées avec une même carte de circuits imprimés 1, les mêmes touches plastiques, la même membrane silicone, en particulier. Seul le plastron plastique est à développer pour chaque option.

## Revendications

1. Façade modulaire de planche de bord automobile, destinée à servir d'interface homme machine à au moins deux systèmes d'équipement automobile à réglages, comprenant un tableau de commande (4, 5) et au moins une carte de circuits imprimés (1) sur laquelle sont montés les composants électriques et électroniques de fonctionnement desdits systèmes, **caractérisée en ce que** ladite carte de circuits imprimés (1) est constituée de deux parties séparées par une ligne de découpe (L) permettant d'amputer ladite carte d'une desdites parties, les composants électriques et électroniques essentiels (12, 13, 14) desdits systèmes d'équipement automobile étant tous montés sur l'autre partie.

2. Façade selon la revendication 1, **caractérisée en ce que** l'ensemble composé par les deux systèmes d'équipement automobile au moins comprend le système autoradio.

3. Façade selon les revendications 1 et 2, **caractérisée en ce que** ladite partie (1Aₛᵤₚ, 1Bₛᵤₚ) pouvant être séparée de la carte de circuits imprimés (1) est la partie qui correspond au système autoradio.

4. Façade selon l'une quelconque des revendications 1 à 3, **caractérisée en ce que** la ligne de découpe (L) est une ligne droite dirigée selon la longueur de la carte de circuits imprimés (1).

5. Façade selon la revendication 1, **caractérisée en ce que** lesdits composants électriques et électroniques essentiels (12, 13, 14) desdits systèmes d'équipement automobile comportent au moins les composants suivants : alimentation électrique, microcontrôleurs, mémoires, interface et connectique.

6. Façade selon l'une quelconque des revendications 1 à 5, **caractérisée en ce que** ne traversent la ligne de découpe (L) que les pistes (15) de circuits imprimés, exclusivement.

7. Façade selon la revendication 6, **caractérisée en ce que** lesdites pistes (15) de circuits imprimés traversent la ligne de découpe (L) selon des lignes sensiblement perpendiculaires à ladite ligne de découpe (L).

8. Façade selon l'une quelconque des revendications 6 et 7, **caractérisée en ce que** lesdites pistes (15) de circuits imprimés sont, dans la zone de la ligne de découpe (L), éloignées d'une distance (D) suffisante, de façon à ce qu'un découpage imprécis ne puisse pas provoquer un court-circuit.

9. Façade selon l'une quelconque des revendications 1 à 8, **caractérisée en ce que** la ligne de découpe (L) est réalisée de façon à permettre l'un des découpages suivants : découpage type ciseaux, découpage type laser, découpage par cassure manuelle.

10. Façade selon la revendication 3, **caractérisée en ce que** ladite partie (1Aₛᵤₚ, 1Bₛᵤₚ) pouvant être séparée de la carte de circuits imprimés qui correspond au système autoradio ne comporte que des composants non essentiels, tels des diodes électroluminescentes, et des contacts pour commutation.

11. Façade selon la revendication 10, **caractérisée en ce que** lesdits composants non essentiels ne sont pas soudés sur ladite partie (1Aₛᵤₚ, 1Bₛᵤₚ) pouvant être séparée de la carte de circuits imprimés (1), lorsque ladite partie (1Aₛᵤₚ, 1Bₛᵤₚ) est réellement séparée de l'autre partie.

## Claims

1. Modular front for a vehicle dashboard, intended to serve as a man-machine interface with at least two automobile equipment systems with settings, comprising a control panel (4, 5) and at least one printed circuit board (1) on which the electrical and electronic components are mounted for the functioning of the said systems, **characterized in that** the said printed circuit board (1) is constituted by two parts separated by a cutting line (L) permitting cutting of the said board of one of the said parts, the essential electrical and electronic components (12, 13, 14) of the said automobile equipment systems all being mounted on the other part.

2. Front according to Claim 1, **characterized in that** the assembly composed of the two automobile equipment systems at least comprises the car radio system.

3. Front according to Claims 1 and 2, **characterized in that** the said part (1Aₛᵤₚ, 1Bₛᵤₚ) being able to be separated from the printed circuit board (1) is the part which corresponds to the car radio system.

4. Front according to any of Claims 1 to 3, **characterized in that** the cutting line (L) is a straight line directed according to the length of the printed circuit board (1).

5. Front according to Claim 1, **characterized in that** the said essential electrical and electronic components (12, 13, 14) of the said automobile equipment systems comprise at least the following components: electrical supply, micro-controllers, memories, interface and connectors.

6. Front according to any of Claims 1 to 5, **characterized in that** only the tracks (15) of printed circuits exclusively pass the cutting line (L).

7. Front according to Claim 6, **characterized in that** the said tracks (15) of printed circuits pass the cutting line (L) according to lines substantially perpendicular to the said cutting line (L).

8. Front according to any of Claims 6 and 7, **characterized in that** the said tracks (15) of printed circuits, in the zone of the cutting line (L), are separated by a sufficient distance (D) such that an imprecise cutting can not cause a short circuit.

9. Front according to any of Claims 1 to 8, **characterized in that** the cutting line (L) is realized so as to allow one of the following cuts: scissor-type cut, laser-type cut, cut by manual break.

10. Front according to Claim 3, **characterized in that** the said part (1Aₛᵤₚ, 1Bₛᵤₚ) being able to be separated from the printed circuit board which corresponds to the car radio system only comprises non-essential components such as electroluminescent diodes, and contacts for switching.

11. Front according to Claim 10, **characterized in that** the said non-essential components are not welded on the said part (1Aₛᵤₚ, 1Bₛᵤₚ) being able to be separated from the printed circuit board (1), when the said part (1Aₛᵤₚ, 1Bₛᵤₚ) is actually separated from the other part.

## Patentansprüche

1. Modulare Vorderseite eines Kraftfahrzeug-Armaturenbretts, die dazu bestimmt ist, als Mensch-Maschinenschnittstelle mit mindestens zwei Kraftfahrzeug-Ausstattungssystemen mit Einstellungen zu dienen, die ein Bedienfeld (4, 5) und mindestens einer Leiterplatte (1) aufweist, auf die die elektrischen und elektronischen Betriebsbauteile der Systeme montiert sind, **dadurch gekennzeichnet, dass** die Leiterplatte (1) aus zwei Teilen besteht, die durch eine Schneidlinie (L) getrennt sind, die es erlaubt, einen der Teile von der Leiterplatte abzutrennen, wobei die wesentlichen elektrischen und elektronischen Bestandteile (12, 13, 14) der Kraftfahrzeug-Ausstattungssysteme alle auf den anderen Teil montiert sind.

2. Vorderseite nach Anspruch 1, **dadurch gekennzeichnet, dass** die Einheit, die aus den mindestens zwei Kraftfahrzeug-Ausstattungssystemen besteht, das Autoradiosystem aufweist.

3. Vorderseite nach den Ansprüchen 1 und 2, **dadurch gekennzeichnet, dass** der Teil (1Aₛᵤₚ, 1Bₛᵤₚ), der von der Leiterplatte (1) getrennt werden kann, der Teil ist, der dem Autoradiosystem entspricht.

4. Vorderseite nach einem der Ansprüche 1 bis 3, **dadurch gekennzeichnet, dass** die Schneidlinie (L) eine gerade Linie ist, die entlang der Länge der Leiterplatte (1) verläuft.

5. Vorderseite nach Anspruch 1, **dadurch gekennzeichnet, dass** die wesentlichen elektrischen und elektronischen (12, 13, 14) Bauteile der Kraftfahrzeug-Ausstattungssysteme mindestens die folgenden Bauteile aufweisen: Netzteil, Mikrocontroller, Speicher, Schnittstelle und Anschlusstechnik.

6. Vorderseite nach einem der Ansprüche 1 bis 5, **dadurch gekennzeichnet, dass** nur die Leiterbahnen (15) von Leiterplatten die Schneidlinie (L) durchqueren.

7. Vorderseite nach Anspruch 6, **dadurch gekennzeichnet, dass** die Leiterbahnen (15) von Leiterplatten die Schneidlinie (L) entlang von Linien durchqueren, die im Wesentlichen zu der Schneidlinie (L) senkrecht liegen.

8. Vorderseite nach einem der Ansprüche 6 und 7, **dadurch gekennzeichnet, dass** die Leiterbahnen (15) von Leiterplatten in dem Bereich der Schneidlinie (L) um eine ausreichende Entfernung (D) entfernt sind, so dass ein ungenaues Schneiden keinen Kurzschluss verursachen kann.

9. Vorderseite nach einem der Ansprüche 1 bis 8, **dadurch gekennzeichnet, dass** die Schneidlinie (L) so hergestellt ist, dass sie eine der folgenden Schneidarten erlaubt: Schneiden mit Schere, Laserschneiden, Schneiden durch manuelles Brechen.

10. Vorderseite nach Anspruch 3, **dadurch gekennzeichnet, dass** der Teil (1Aₛᵤₚ, 1Bₛᵤₚ), der von der Leiterplatte, die dem Autoradiosystem entspricht, getrennt werden kann, nur unwesentliche Bauteile, wie zum Beispiel Leuchtdioden und Umschaltkontakte aufweist.

11. Fassade nach Anspruch 10, **dadurch gekennzeichnet, dass** die unwesentlichen Bauteile nicht auf den Teil (1Aₛᵤₚ, 1Bₛᵤₚ) geschweißt sind, der von der Leiterplatte (1) getrennt werden kann, wenn der Teil (1Aₛᵤₚ, 1Bₛᵤₚ) tatsächlich von dem anderen Teil getrennt wird.
